(19) **Europäisches Patentamt**

**European Patent Office**

**Office européen des brevets**

(11) **EP 0 341 862 B1**

(12) **EUROPEAN PATENT SPECIFICATION**

(45) Date of publication and mention
of the grant of the patent:
**10.01.1996 Bulletin 1996/02**

(51) Int Cl.6: **H03M 13/00**

(21) Application number: **89304190.5**

(22) Date of filing: **26.04.1989**

(54) **Error location system**

Fehlerortungssystem

Système de localisation d'erreurs

(84) Designated Contracting States:
**DE FR GB IT NL**

(30) Priority: **12.05.1988 US 193381**

(43) Date of publication of application:
**15.11.1989 Bulletin 1989/46**

(73) Proprietor: **QUANTUM CORPORATION**
**Milpitas, California 95035 (US)**

(72) Inventor: **Weng, Lih-Jyh**
**Lexington, Massachusetts 02173 (US)**

(74) Representative: **Goodman, Christopher et al**
**Nottingham NG1 1LE (GB)**

(56) References cited:
**US-A- 3 418 629**

• **WESCANEX 88 - DIGITAL COMMUNICATIONS CONFERENCE PROCEEDINGS; 11,12 May 1988 Saskatoon, Saskatchewan, Canada pages 67 - 71; Y.R. SHAYAN et al.: "Applications of forward error coding in mobile communication systems"**
• **IEEE TRANSACTIONS ON INFORMATION THEORY. March 1969, NEW YORK US pages 329 - 335; R.T. CHIEN et al.: "Hybrid methods for finding roots of a polynomial - With application to BCH decoding"**
• **IEE PROCEEDINGS F. COMMUNICATIONS, RADAR & SIGNAL vol. 134, no. 6, October 1987, STEVENAGE GB pages 629 - 632; Y.R. SHAYAN et al.: "Binary- decision approach to fast Chien search for software decoding of BCH codes"**

## Description

### FIELD OF INVENTION

This invention relates to error correction code decoding mechanisms in general and more particularly to the decoding of Bose-Chaudhuri-Hocquenghem (BCH) error correction codes, including Reed-Solomon error correction codes.

### DESCRIPTION OF PRIOR ART

The importance of error correction coding of data in digital computer systems has increased greatly as the density of the data recorded on mass storage media, more particularly magnetic disks, has increased. With higher recording densities, a tiny imperfection in the recording surface of a disk can corrupt a large amount of data. In order to avoid losing that data, error correction codes ("ECC's") are employed to, as the name implies, correct the erroneous data.

Before a string of data symbols is recorded on a disk, it is mathematically encoded to form ECC symbols. The ECC symbols are then appended to the data string to form code words - data symbols plus ECC symbols - and the code words are then stored on the disk. When the stored data is to be retrieved from the disk, the code words are mathematically decoded. During decoding any errors in the data are detected and, if possible, corrected through manipulation of the ECC symbols [For a detailed description of decoding see Peterson and Weldon, Error Correction Codes, 2d Edition, MIT Press, 1972].

Stored digital data can contain multiple errors. One of the most effective types of ECC used for the correction of multiple errors is a Reed-Solomon code [For a detailed description of Reed-Solomon codes, see Peterson and Weldon, Error Correction Codes]. Error detection and correction techniques for Reed-Solomon ECC's are well known. Id. One such technique begins with again encoding the data string in the retrieved code word to generate ECC symbols and then comparing these ECC symbols with the ECC symbols in the retrieved code word, i.e. the ECC symbols generated by the pre-storage encoding of the data, to detect any errors in the retrieved code word data. [For a detailed discussion of this error detection technique, see United States Patent 4,413,339 issued to Riggle and Weng].

The comparison of the two sets of ECC symbols is made by exclusive OR'ing ("XOR'ing") them. If there are no errors in the retrieved code word data, the XOR'ing will produce a string of symbols containing only zeros. If there are errors in the retrieved data, the result of the XOR'ing will be non-zero and error correction will be then performed, if possible. If the number of non-zero symbols which result from the XOR'ing is less than the number of errors the code is designed to correct, all the errors are in the ECC symbols, i.e. there are no errors in the data string, and no error correction is required. If the number of non-zero resulting symbols is equal to or greater than the number of errors the code is designed to correct, the retrieved data string contains one or more errors and error correction is then performed.

In order to correct the data errors, the locations and the magnitudes or "values" of the errors must be determined. The first step in determining the error locations and the error values is to form error syndrome equations from the results of the XOR'ing of the ECC symbols. [For a detailed discussion of the generation of the error syndromes refer to United States Patent 4,413,339 issued to Riggle and Weng]. The error syndromes are then used to generate polynomials which, when evaluated, will identify the location and the value of each of the errors.

Alternatively the error syndromes may be formed by using the entire retrieved code word. This will avoid the steps of re-encoding the retrieved data and comparing the ECC symbols with the retrieved ECC symbols. However, error syndromes must then be generated for every code word, even those without errors, although in the latter case the syndromes will be identically zero. Where there are errors, i.e. the error syndromes are not zero, the syndromes are then used to locate and correct any errors in exactly the same manner as the syndromes formed from the results of the XOR'ing of the ECC symbols. The choice between these two arrangements may, for example, depend on whether the syndromes are generated in software or hardware.

The calculation of the values of the errors is necessarily dependent on their locations. The error locations are calculated by using the error syndromes to generate an error locator polynomial $\delta(x)$ of degree v, where v is the number of errors. The solutions or roots of the equation $\delta(x) = 0$ designate the locations of the errors. These roots are of the form $x_i = \alpha^i$, where $\alpha$ is the primitive element of the Galois Field $GF(p^q)$ used to encode the data.

The roots of the error locator equation are typically found using a Chien search. The Chien search systematically tries each element x of $GF(p^q)$ as a possible solution to $\delta(x) = 0$. Each time a new value of x is tried, v Galois Field multiplication operations and v Galois Field addition operations are performed to determine if x is a solution. Once all v roots have been found, they are substituted into an error evaluator polynomial $\Phi(x)$ and the corresponding error magnitudes, or values are calculated. The data can then be corrected by multiplying the erroneous data symbol by a correction symbol to produce an error-free data symbol.

The time it takes to perform error correction significantly affects the rate at which data can be retrieved from a storage device. As the potential for errors in stored data increases with the use of higher recording densities, slow error correction has a material effect on the average speed with which the data can be retrieved. The increased data retrieval time in turn limits the speed of all computer applications that require the retrieval of stored data. This speed limitation occurs at a time when computer system technology advances have otherwise made possible faster data transfer operations.

Thus there is a need for an error correction technique that can be performed more quickly than the methods currently in use. Such a technique will enable computer systems to operate at the faster rates permitted by the advances in the state of the art computer technology.

## SUMMARY OF THE INVENTION

The invention is an error correcting system which calculates the error locations with a reduced number of operations. The error correcting system can thus more quickly correct the errors. Basically, each time a root of the error locator equation is found, the equation is modified to reduce the number of Galois Field multiplication and addition operations that are required to evaluate as possible solutions the remaining values of x. The modification, in effect, reduces the degree of the equation. All of the roots of the equation may be found using this technique, or the technique may be used to find several of the roots and a fast-decode method designed specifically for solving equations having two, three or four roots may be used to find the remaining roots.

In brief summary the error locator equation is:

$$1 + \delta_1 {}^* x + \delta_2 {}^* x^2 + \delta_3 x^3 + ... + \delta_{v-1} {}^* x^{v-1} + \delta_v {}^* x^v = 0 \qquad (1)$$

where "+" and "*" represent Galois Field addition and Galois Field multiplication, respectively, and "v" is the number of errors in the data. As described below, the coefficients of equation (1) are substituted into a succession of v error location formulas along with successive values of x, to determine if the various x's are roots of equation (1). Since equation (1) is of degree v, each such determination requires v multiplication and v addition operations. When the first root is found, extraction of the root corresponds to reducing the degree of equation (1) by one, to (v-1), and also to reducing the number of error location formulas by one to (v-1). Thus substitution in the error location formulas of further values of x to find the next root requires one fewer addition operation and one fewer multiplication operation.

Thereafter, when another root is found, the error location formulas are further reduced by one. This procedure is repeated until, depending on the system utilized, all v roots are found or v is reduced to a value of 2, 3 or 4, and a fast-decoding method is utilized to find the remaining roots.

Reducing the number of multiplication and addition operations required to find the remaining roots of the error locator equation each time a root is found speeds-up the error correction process. The faster errors in the data can be corrected, the faster the data can be transmitted to the remainder of the data processing system. This is particularly important as data is recorded at increased densities, leading to more errors, and thus requiring more error correction.

## DESCRIPTION OF THE DRAWINGS

This invention is pointed out with particularity in the appended claims. The above and further advantages of this invention may be better understood by referring to the following description taken in conjunction with the accompanying drawings, in which:

Figure 1 is a functional block diagram of a decoding system built in accordance with a first embodiment of the invention;
Figures 2A-B are flow charts of the steps involved in the operation of the first embodiment of the invention;
Figure 3 is a functional block diagram of a decoding system built in accordance with a second embodiment of the invention; and
Figures 4A-B are flow charts of the steps involved in the operation of a second embodiment of the invention.

## DETAILED DESCRIPTION

It should be understood that all addition and multiplication operations performed by the inventive system are Galois Field operations and that the Galois Fields are of the form $GF(p^q)$.

Conventional techniques are used to generate the error syndromes from the data and then to generate the error locator equation, $\delta(x) = 0$.

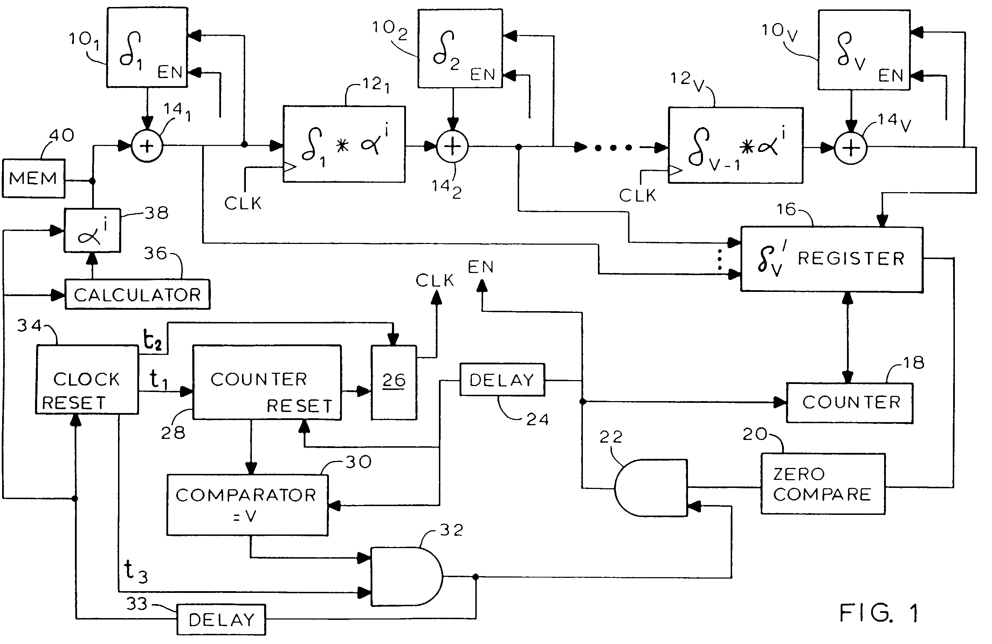

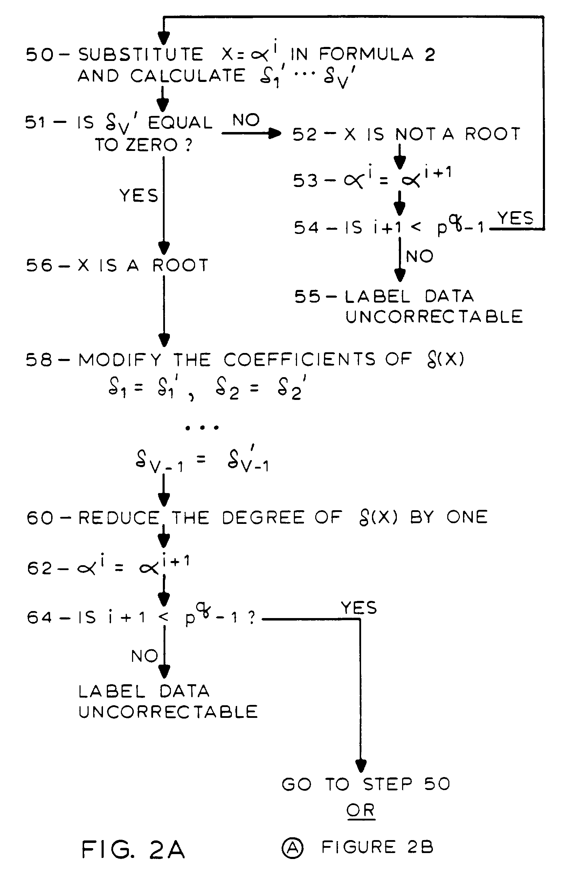

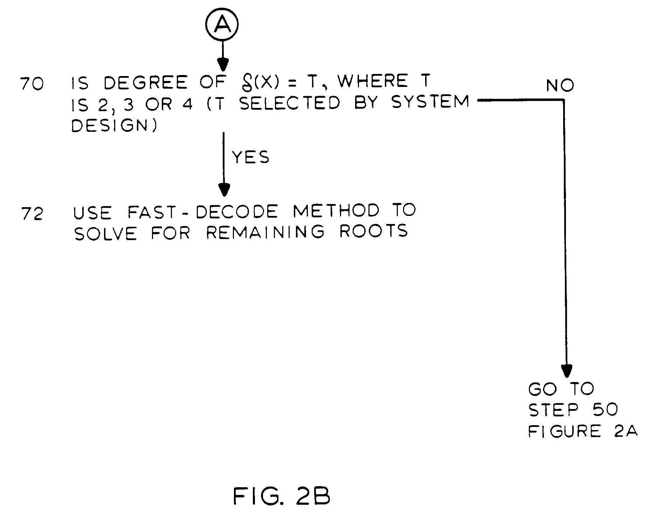

With reference to Figures 1 and 2, an error correcting system 8 evaluates $\delta(x)$ at various values of x using the following set of error location formulas:

$$\delta_1' = \delta_1 + \alpha^i \qquad (2_1)$$

$$\delta_2' = \delta_1'^* \alpha^i + \delta_2 \qquad (2_2)$$

$$\delta_v' = \delta_{v-1}'^* \alpha^i + \delta_v \qquad (2_v)$$

where $\alpha^i = x$ and the terms $\delta_j'$ are modifications of the $\delta_j$ terms, not derivatives of these terms (step 50). Successive values of $\delta_j'$ are calculated from the previous values until the value of $\delta_v'$ is determined. If $\delta_v'$ is equal to ZERO for a particular x, x is a root of equation (1) (steps 51, 56).

Formulas $2_1$-$2_v$ are evaluated using registers $10_1$-$10_v$ (generally referred to by the numeral 10), Galois Field multipliers $12_1$-$12_v$ (generally referred to by the numeral 12) and Galois Field adders $14_1$-$14_v$ (generally referred to by the numeral 14). To begin, the coefficients of equation (1) are stored in registers 10, a counter 18 and a comparator 30 are initialized to v, and an $\alpha$ register 38 is initialized to a first value of x, $x = \alpha^i$ where i is typically zero.

Register 38 applies the first x value to each of the multipliers 10 and to the adder $14_1$. The adder $14_1$ calculates the sum:

$$\delta_1' = \delta_1 + \alpha^i.$$

This sum is applied to both to a register 16 where it is stored and to a multiplier $12_1$ which, when clocked by a clock 34 through gates 26 as discussed in more detail below, calculates the product:

$$\delta_1'^* \alpha^i$$

This product is applied to adder $14_2$, which calculates the sum, $\delta_2'$. The value of $\delta_2'$ is stored in a register 16, and it is also used to calculate the product $\delta_2'^* \alpha^i$. This product is then used to calculate $\delta_3'$ and the value of $\delta_3'$ is stored in register 16. The sums $\delta_j'$ and the products $\delta_j'^* \alpha^i$ are similarly calculated for each coefficient using the multipliers 12 and the adders 14, and the each of the values of $\delta_j'$ are in turn stored in the register 16.

Register 16 is addressed by counter 18, which is set to the value v. Thus the register 16 applies the contents of the storage location addressed by the counter to its output. Accordingly, when the term $\delta_v'$ is applied to the register 16, it appears also at its output. This output is then applied to a zero compare 20 where it is compared to ZERO. If $\delta_v'$ equals ZERO, indicating that $\alpha^i$ is a root of the error location equation, the output of the zero compare 20 is asserted. If $\delta_v'$ does not equal ZERO, indicating $\alpha^i$ is not a root of the error locator equation, the output of the zero compare 20 is not asserted.

Clock 34 controls the timing of the various multipliers and gates using three timers, namely $t_1$, $t_2$, and $t_3$, to avoid race conditions. Timer $t_1$ clocks counter 28 which, in effect, counts the number of multiplication operations performed in calculating $\delta_v'$. Timer $t_2$, which is slightly slower than $t_1$, clocks gates 26 which in turn clock multipliers 12. Timer $t_3$, which is slightly slower than timer $t_2$, acts as an input to an AND gate 32.

To begin calculating the formulas $2_1$-$2_v$, the sum $\delta_i'$ is calculated by adder $14_1$ as described above and the sum is applied to multiplier $12_1$. Timer $t_1$ clocks counter 28, and the counter applies a count of one, signalling the first of v multiplication operations, to the gates 26. Thereafter the gates 26, when clocked by timer $t_2$, apply a clock pulse to the first multiplier $12_1$ and the first product, $\delta_1'^* \alpha^i$, is calculated. The output of counter 28 is also applied to the comparator 30, where it is compared to v. The comparator 30 asserts its output when the count equals v, indicating the occurrence of the "vth" multiplication operation. If the count of counter 28 is not equal to v, the output of the comparator 30 remains de-asserted.

Assuming that the count does not equal v, the first product calculated by multiplier $12_1$ is applied to adder $14_2$ which adds it to $\delta_2$ to produce the sum $\delta_2'$. This sum is stored in the register 16 and is also applied to multiplier $12_2$. Timer $t_1$ clocks the counter 28, which increases the count to two, indicating that the second multiplication is to occur. The output of counter 28 is applied to gates 26 which, when subsequently clocked by timer $t_2$, clock multiplier $12_2$ which then calculates the product:

$$\delta_2'^* \alpha^i.$$

This product is applied to adder $14_3$ which calculates the sum $\delta_3'$, and the sum is again stored in register 16. The same series of addition and multiplication operations continue and the sums $\delta_j'$ are stored in the register 16 until the count of counter 28 equals v, indicating the start of the calculation of formula $(2_v)$. When the count of counter 28 equals v, the output of the comparator 30, which is comparing the count to v, is asserted. The output is applied to one input of an AND gate 32, which has a second input connected to timer $t_3$. Thus when timer $t_3$ is pulsed, the output of the AND gate 32 is asserted.

The output is applied to one input of AND gate 22, which has a second input connected to the output of zero compare 20. If the sum $\delta_v'$ is equal to ZERO, that is, x is a root, the output of AND gate 22 will then be asserted. Otherwise, if $\delta_v'$ is not equal to ZERO, the output of the zero compare 20 remains de-asserted and thus the output of AND gate 22 is not asserted.

If x is not a root of equation (1), a new value of x is substituted into formulas $2_1$-$2_v$ and the sum $\delta_v'$ is calculated and compared to ZERO to determine if it is a root (steps 52-54). Thus the asserted output of AND gate 32 is applied, through delay 33, to i) reset the clock 34, ii) load a new value of $x=\alpha^{i+1}$ from calculator 36 into register 38, and iii) enable calculator 36 to calculate a new value of x. The value of x loaded into register 38 is then evaluated as a possible root, in the manner described above. This evaluation involves v multiplication operations and v addition operations.

If x is a root, the coefficients of equation (1), and accordingly the formulas $2_1$-$2_v$, are modified and the degree of equation (1), that is, the value of v, is reduced by one (steps 58-60). Thereafter, a new value of x is substituted into the modified formulas $2_1$-$2_v$ and a new sum $\delta_v'$ is calculated (steps 62-64). With further reference to Figure 1, if x is a root the sum $\delta_v'$ is equal to ZERO and the output of the zero compare 20 is asserted. This output is applied to one input of AND gate 22. The second input of AND gate 22 is connected to the output of AND gate 32 which is asserted at the next $t_3$ clock pulse. Thus, two gate delays after $t_3$ is pulsed, the output of AND gate 22 is asserted.

The asserted output of AND gate 22 is applied simultaneously to i) a memory 40, which stores the value $\alpha^i$ as a root; ii) the counter 18, which decrements its count to v-1; and iii) the registers 10, which load the sums $\delta_j'$. The output of gate 22 is also applied a short time later, through delay 24, to the comparator 30, which decrements the value of v stored therein by one. Thereafter, clock 34 is reset through delay 33 and a new value of $x=\alpha^{i+1}$ is loaded into the $\alpha$ register 38. The calculator 36 is also enabled to begin calculating a new value of $x=\alpha^{i+1}$.

When timer $t_1$ is pulsed, the evaluation operations begin, using the modified coefficients, $\delta_j'$, and the new value of x. The evaluation involves one less multiplication operation and one less addition operation. Thus the time required for the evaluation is reduced from the time taken to evaluate the previous value of x as a root.

Each value of $x=\alpha^{i+1}$ calculated by calculator 36 is checked against the code block length, not exceeding $P^q$-1, to determine if the value is a "new" value of x (steps 54,64). If i+1 is less than or equal to the code block length, the value of $x=\alpha^{i+1}$ is a new value. If, however, i+1 is greater than the code length, the calculated value of $x=\alpha^{i+1}$ corresponds to an error location outside of the code length. If the value of x calculated by calculator 36 is not a "new" x value, it indicates that all the roots of equation (1) can not be found and thus the error locations can not all be determined to be within the code length. Thus calculator 38 notifies a system controller (not shown) that the data is uncorrectable (steps 55, 65).

All the roots of equation 1 which are of the form $x = \alpha^i$ can be found using the technique described above. However, known methods of finding the roots of degree 2, 3 or 4 equations in $GF(p^q)$ may be used to find the remaining roots (steps 70-71, Figure 2B). The particular method used will depend on system design.

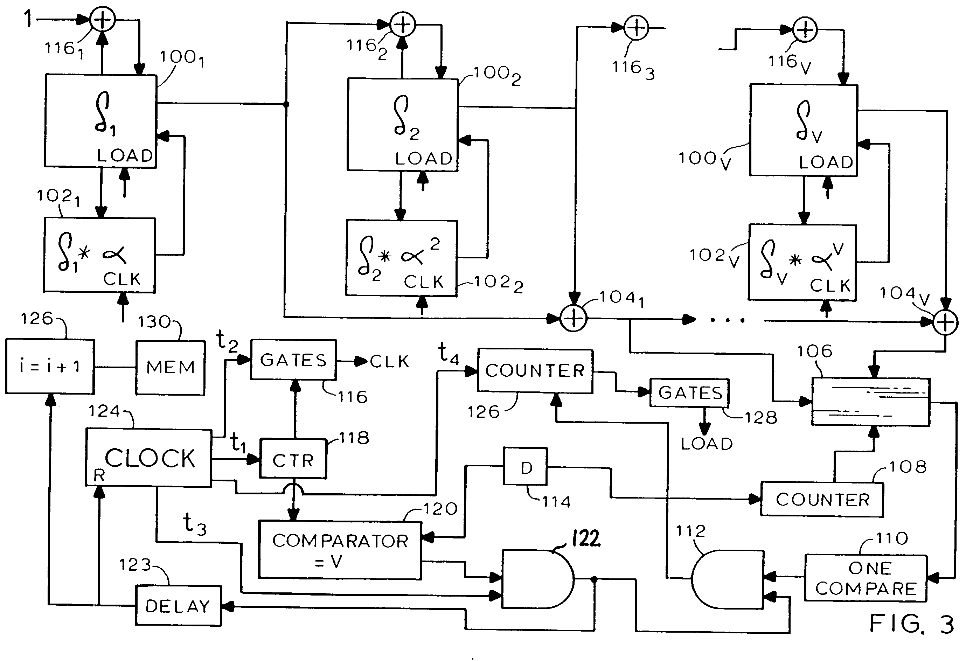

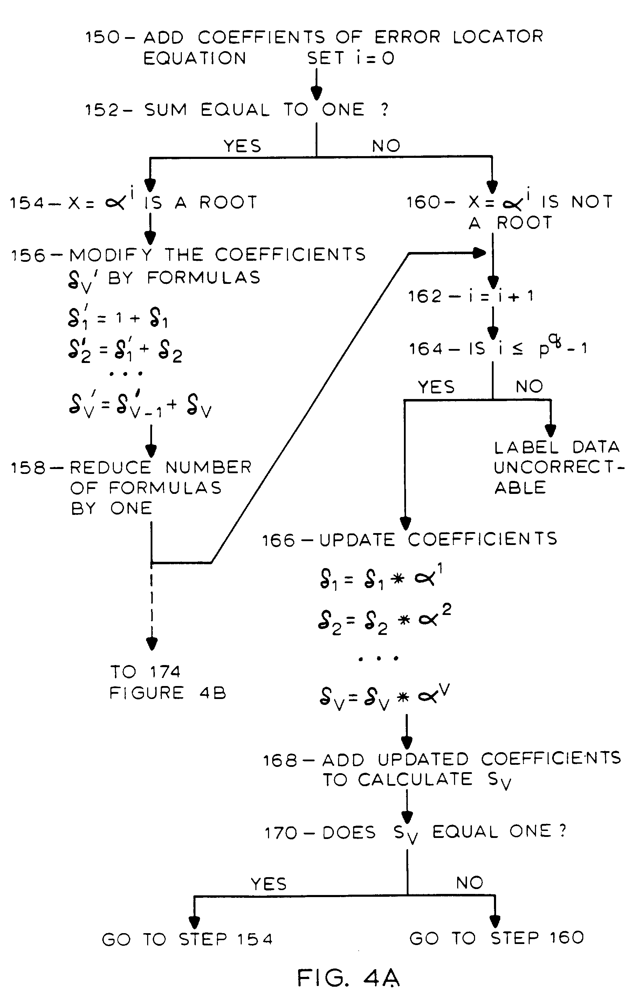

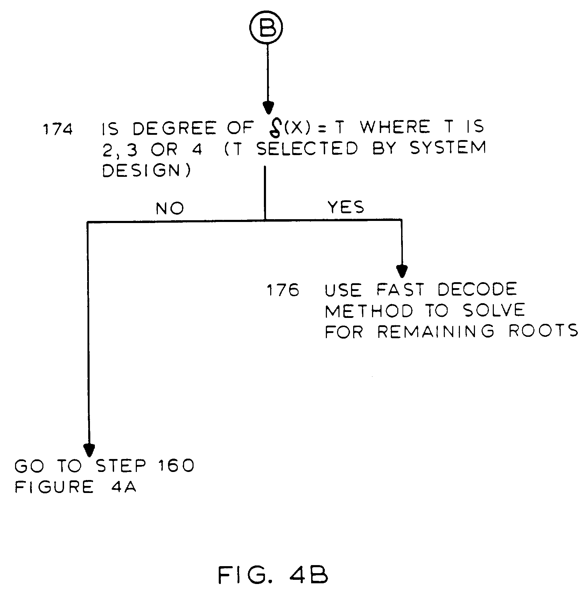

A second embodiment uses a direct modification of the Chien search to find the roots of the error locator equation. With respect to Figures 3 and 4, an error correcting system 99 iteratively evaluates $\delta(x)$ by first adding the coefficients of equation (1) to produce the sum $S_v$ and comparing the sum to ONE (step 150-152). Thereafter $\delta(x)$ is evaluated using the following set of iterative error location formulas:

$$\delta_1 = \delta_1 * \alpha \; (3_1)$$

$$\delta_2 = \delta_2 * \alpha^2 \; (3_2)$$

$$\ldots \; \delta_v = \delta_v * \alpha^v \; (3_v)$$

(step 166). Thus new values of $S_j$ are calculated each iteration and after i iterations the formulas have calculated $\delta_k = \delta_{k(original)} * (\alpha^k)^i$. After each iteration the $\delta_j$ terms are added to produce the sum $S_v$ (step 168). If $S_v$ is equal to ONE for a particular iteration, for example the $i^{th}$ iteration, $x=\alpha^i$ is a root (step 171).

Formulas $3_1$-$3_v$ are evaluated using registers $100_1$-$100_v$ (generally referred to by the numeral 100), Galois Field multipliers $102_1$-$102_v$ (generally referred to by the numeral 102) and Galois Field adders $104_1$-$104_v$ (generally referred to by the numeral 104). To begin, the coefficients of equation (1) are stored in registers 100, a counter 108 and a comparator 120 are each initialized to v, and a register 126 is initialized to a first value of i = 0.

The multipliers, counters and timers are clocked by a clock 124, which operates in the same manner as the clock 34 described above with reference to Figure 1. Each intermediate sum, $S_j$, calculated in adders 104 is applied to a register 106 which is addressed by counter 108. When the sum $S_v$ is applied to the register 106, it appears at the output, also. The sum $S_v$ is then compared to ONE in a one compare 110. If the sum $S_v$ equals ONE, $x=\alpha^i$ is a root of equation (1). If the sum $S_v$ does not equal ONE, $x=\alpha^i$ is not a root.

If x is not a root of equation (1), formulas $3_1$-$3_v$ are iteratively updated and the sum $S_v$ is calculated (steps 166-168). The sum is then compared to ONE to determine if the x corresponding to the particular iteration is a root (step 170). Accordingly, system 99 operates in a manner similar to the system described with reference to Figure 1. Thus the clock 124 is reset and the formulas are iteratively updated, corresponding to the earlier-described system trying a new value of x. The new sum Sv is then evaluated to detemine if x is a root. This evaluation involves v multiplication operations and v addition operations.

If x is a root, the coefficients of formulas $3_1$-$3_v$ are modified and the degree of the equation, that is, the value of v, is reduced by one (steps 156-158). This reduces the number of multiplication and addition operations required to evaluate the formula for the next iteration. The coefficients $\delta_j$ are modified as follows:

$$\delta_1' = 1 + \delta_1$$

$$\delta_2' = \delta_1' + \delta_2$$

$$... \ \delta_v' = \delta_{v-1}' + \delta_v$$

where the terms $\delta_j'$ are modifications of the $\delta_j$ terms, not derivatives of these terms (step 156). The modified coefficients are then substituted into formulas $3_1$-$3_v$ and the formulas are evaluated for an associated next value of x.

With further reference to Figure 3, if the sum $S_v$ is equal to ONE if $x=\alpha^i$ is a root and the output of the one compare 110 is asserted. Thus the output of AND gate 112 is asserted two gate delays after the output of AND gate 122 is asserted at the next $t_3$ clock pulse. The asserted output of AND gate 112, which signifies that $x=\alpha^i$ is a root of equation (1), is applied simultaneously to i) a memory 130, which stores the value $\alpha^i$ as a root; ii) the counter 108, which decrements its count to v-1; and iii) a counter 126, which, through gates 128, enables successive registers 100 to load the associated sums $\delta_j$. The output of gate 112 is also applied a short time later, through delay 123, to the comparator 120, which decrements the value of v stored therein by one.

Thereafter, clock 124 is reset through delay 123, and the evaluation operations begin, using the modified coefficients, when timer $t_1$ is pulsed. The evaluation involves one less multiplication operation and one less addition operation. Thus the time required for the evaluation is reduced from the time taken to evaluate the iteratation corresponding to the previous value of x.

The value of i in registers 126, which is updated for each iteration is continuously checked against the code block length, $P^q$-1, to determine if the value is a "new" value of x (step 164) in the same manner as calculator 36 described with reference to Figure 1. If x is a new value, an $i^{th}$ iteration will be performed. If x is not a "new" value, it indicates that all the roots of equation (1) can not be found in GF($p^q$) and thus the error locations can not all be determined. The system controller is thus notified that the data is uncorrectable (step 165).

All the roots of equation 1 of the form $x = \alpha^i$ can be found using the technique described above. However, known methods of finding the roots of degree 2, 3 or 4 equations in GF($p^q$) may be used to find the remaining roots (step 176). The particular method used will depend on system design.

The foregoing description has been limited to two specific embodiments of this invention. It will be apparent, however, that variations and modifications may be made to the invention, with the attainment of some or all of the advantages of the invention. Therefore, it is the object of the appended claims to cover all such variations and modifications as come within the scope of the invention as defined by the appended claims.

## Claims

1. A method of determining the locations of erroneous symbols in a received data code word which is formulated by encoding data symbols in accordance with a BCH code, said method comprising the steps of:

    A. receiving a data code word;
    B. determining if the code word contains errors;
    C. if the code word contains errors, generating an error locator equation relating to the code word, the error locator equation being of the form:

$$1 + \delta_1 {}^* x + \delta_2 {}^* x^2 + \delta_3 {}^* x^3 + ... + \delta_{v-1} {}^* x^{v-1} + \delta_v {}^* x^v = 0,$$

where * represents multiplication over a Galois Field used to encode the data symbols and + represents addition over the Galois Field and the roots of the error locator equation correspond to the locations of erroneous code word symbols;
    the method being characterised by the steps of:
    D. determining if $\alpha^i$, where $\alpha^i$ corresponds to the location of a data symbol in the code word, is a root of the error locator equation, and thereby determining that the corresponding data symbol is erroneous, by:

        i. calculating (50), using the coefficients of the error locator equation, the value of $\delta_v'$ by iteratively calculating $\delta_j'$ j=1 to v according to the formulas:

$$\delta_1' = \delta_1 + \alpha^i$$

$$\delta_2' = \delta_1' {}^* \alpha^i + \delta_2$$

$$... \ \delta_v{}' = \delta_{v-1}{}'*\alpha^i + \delta_v$$

ii. comparing (51) $\delta_v{}'$ to ZERO, and

iii. storing $\alpha^i$ as corresponding to the location of an erroneous data code word symbol if $\delta_v{}'$ equals ZERO, which indicates that $\alpha^i$ is a root of the error locator equation;

E1. if $\alpha^i$ is not a root, trying as a root of the error locator equation a next value of $\alpha^i = \alpha^{i+1}$ (53,50), which corresponds to the next data symbol location, by repeating step D;

E2. if $\alpha^i$ is a root;

i. updating (58) the error locator equation and the error locator formulas by replacing the coefficients with the $\delta_j{}'$ values calculated in step D and thereby reducing (60) the degree of the equation and the number of formulas,

ii. selecting a next value of $\alpha^i = \alpha^{i+1}$ (62), which corresponds to the next data symbol location;

F. repeating steps D and E until a predetermined number of error locations have been found.

2. The method of claim 1 further including the steps of:

G. determining (72) the remaining error locations by finding the roots of the reduced error locator equation by using a fast-decode method that finds the roots of an equation of the predetermined degree; and

H. transmitting the received code word and the stored $\alpha^i$ values corresponding to the error locations to an error correction circuit for correction of the erroneous data symbols.

3. The method of claim 1, wherein the step of repeating steps D and E further includes:

a. repeating the steps (50,51) until either all the roots of the error locator equation are found or the $\alpha^i$ values corresponding to all possible code word symbol locations have been tried as possible roots; and

b. if all the roots have been found, transmitting the received code word and the stored $\alpha^i$ values corresponding to the error locations to an error correction circuit for correction of the erroneous data symbols; or

c. if the $\alpha^i$ values corresponding to all possible code word symbol locations have been tried as possible roots and all the roots have not been found, labeling (55) the data code word uncorrectable.

4. A method of determining the locations of erroneous symbols in a received data code word which is formulated by encoding data symbols in accordance with a BCH code, said method comprising the steps of:

A. receiving a data code word;

B. determining if the code word contains errors;

C. if the code word contains errors, generating an error locator equation relating to the code word, the error locator equation being of the form:

$$1 + \delta_1*x + \delta_2*x^2 + \delta_3*x^3 + ... + \delta_{v-1}*x^{v-1} + \delta_v*x^v = 0,$$

where * represents multiplication over a Galois Field used to encode the data symbols and + represents addition over the Galois Field and the roots of the error locator equation corresponds to the locations of erroneous code word symbols;

the method being characterised by the steps of

D. determining if $\alpha^i$, where $\alpha^i$ corresponds to the location of a data symbol in the code word, is a root of the error locator equation, and thereby determining that the corresponding data symbol is erroneous, by:

i. setting (150) an iteration counter to 0;

ii. adding (150) the coefficients of the error locator equation, and

iii. if the sum equals ONE (152,154) indicating $\alpha^i$ is a root of the error locator equation, storing the value $\alpha^i$, where i equals the count of the iteration counter;

E1. if $\alpha^i$ is a root (154), updating the error locator equation by replacing (156) the coefficients and reducing (158) the degree of the equation, said coefficients of the error locator equation being updated by replacing (156) them with $\delta_j{}'$ values calculated using, as appropriate, the formulas:

$$\delta_1' = 1 + \delta_1$$

$$\delta_2' = \delta_1' + \delta_2$$

$$... \ \delta_v' = \delta_{v-1}' + \delta_v;$$

the resulting error location equation having v-1 terms;

E2. if $\alpha^i$ is not a root (160), updating (166) the coefficients of the error locator equation using the fomulas:

$$\delta_1 = \delta_1 * \alpha$$

$$\delta_2 = \delta_2 * \alpha^2$$

$$\delta_v = \delta_v * \alpha^v;$$

F. incrementing (162) said counter by one;

G. repeating steps D through F for successive values of $\alpha^i$.

**5.** The method of claim 4 wherein the steps D and F are repeated until either all the roots of the error locator equation are found or the $\alpha^i$ values corresponding to all possible code word symbol locations have been tried as possible roots, and the method further includes the step of

a. if all the error locations have been found, transmitting the received code word and the stored $\alpha^i$ values corresponding to the error locations to an error correction circuit for correction of the erroneous data symbols; or

b. if the $\alpha^i$ values corresponding to all possible code word symbol locations have been tried as possible roots and all the roots have not been found, labeling the data code word uncorrectable.

**6.** The method of claim 4 further including repeating steps D-F for successive values of $\alpha^i$ until either a predetermined number of roots are found and the reduced error locator equation has a predetermined degree (174) or the $\alpha^i$ values corresponding to all possible code word locations have been tried as possible roots; and

a. if the $\alpha^i$ values corresponding to all possible code word locations have not been tried:

i. determining (176) the remaining error locations by using a fast-decode method designed to find the roots of an equation of the predetermined degree, and

ii. transmitting the received code word and the $\alpha^i$ values corresponding to the error locations to an error correction circuit for correction of the erroneous data symbols, or

b. if the $\alpha^i$ values corresponding to all possible code word locations have been tried labeling the data code word uncorrectable.

**7.** An apparatus for determining the locations of erroneous symbols in a received data code word which is formulated by encoding data symbols in accordance with a BCH code, said apparatus including:

A. means for receiving a data code word;

B. means for determining if the code word contains errors;

C. means for generating, for a code word that contains errors, an error locator equation relating to the code word, the error locator equation being of the form:

$$1 + \delta_1 * x + \delta_2 * x^2 + \delta_3 * x^3 + ... + \delta_{v-1} * x^{v-1} + \delta_v * x^v = 0,$$

where * represents multiplication over a Galois Field used to encode the data symbols and + represents addition over the Galois Field and the roots of the error locator equation correspond to the locations of erroneous code word symbols;

the apparatus being characterised by

D. calculating means (10,12,14) for calculating for $\alpha^i$, where $\alpha^i$ corresponds to the location of a data code word symbol, using the coefficients of the error locator equation, the value of $\delta_v'$ by iteratively calculating $\delta_j'$ j = 1 to v, according to the formulas:

$$\delta_1' = \delta_1 + \alpha^i$$

$$\delta_2' = \delta_1'{}^*\alpha^i + \delta_2$$

$$\delta_v' = \delta_{v-1}'{}^*\alpha^i + \delta_v$$

E. means (40) for storing $\alpha^i$ as an indicator of the location of an erroneous symbol if $\delta_v'$ equals ZERO, which indicates that $\alpha^i$ is a root of the error location equation;

F. updating means (20,22,EN,10), responsive to finding an $\alpha^i$ value which is a root, for updating the error location equation and the error location formulas by replacing the coefficients with the $\delta_j$ values calculated by said calculating means and thereby reducing the degree of the error locator equation and the number of formulas; and supplying the updated error locator equation to said calculating means (10,12,14);

G. means (36,38) for supplying to said calculating means a next value of $\alpha^i = \alpha^{i+1}$;

H. said calculating means (10,12,14) calculating the value of $\delta_v'$ for the $\alpha^i$ value supplied to it until a predetermined number of roots are found.

8. The apparatus of claim 7 wherein the calculating means (10,12,14) finds the remaining error locations by using a fast-decode method designed to solve an equation of the predetermined degree.

9. The apparatus of claim 8 further including a means for correcting the errors in the received code word using the $\alpha^i$ values corresponding to the error locations if all the roots of the error location equation are determined.

10. The apparatus of claim 7 wherein the means (36,38) for supplying the $\alpha^i$ values to the calculating means either supplies all values up to the block length of the code used to encode the data or supplies values only until all error locations are determined.

11. An apparatus for determining the locations of erroneous symbols in a received data code word which is formulated by encoding data symbols in accordance with a BCH code, said apparatus including:

A. means for receiving a data code word;

B. means for determining if the code word contains errors;

C. means for generating, for a code word that contains errors, an error locator equation relating to the code word, the error locator equation being of the form:

$$1 + \delta_1{}^*x + \delta_2{}^*x^2 + \delta_3{}^*x^3 + ... + \delta_{v-1}{}^*x^{v-1} + \delta_v{}^*x^v = 0,$$

where * represents multiplication over a Galois Field used to encode the data symbols and + represents addition over the Galois Field and the roots of the error locator equation correspond to the locations of erroneous code word symbols;

D. an iteration counter (126), set to an initial value;

E. an adder (100,104) for adding the coefficients of the error locator equation;

F. storage means (130) for storing the value $\alpha^i$, where i equals the count of the iteration counter, as an indicator of the location of an erroneous symbol if the coefficient sum equals ONE, which indicates that $\alpha^i$ is a root of the error locator equation;

G. updating means including:

i. cascaded adding means for updating the coefficients of the error locator equation when $\alpha^i$ is a root, that is, when an error location is found, by replacing the coefficients and reducing the degree of the error locator equation, said coefficients of the error locator equation being updated by replacing them with $\delta_j$ values calculated using, as appropriate, the formulas:

$$\delta_1' = 1 + \delta_1$$

$$\delta_2' = \delta_1' + \delta_2$$

$$... \; \delta_v' = \delta_{v-1}' + \delta_v$$

the resulting error location equation having v-1 terms; said updating means supplying the updated coefficients to the adder, or

ii. multiplication means (102) for updating the coefficients of the error locator equation, if an $\alpha^i$ value is not a root, using the formulas:

$$\delta_1 = \delta_1 * \alpha$$

$$\delta_2 = \delta_2 * \alpha^2$$

$$... \delta_v = \delta_v * \alpha^v$$

said updating means supplying the updated coefficients to the adder;

H. means (124) for incrementing said iteration counter (126) each time said updating means supplies updated coefficients to said adder, provided that all the roots have not been found or i does not exceed the code block length of the code used to encode the data;

I. means for correcting the errors in the code word using the stored $\alpha^i$ values if all the roots are found; and

J. means for labeling the code word uncorrectable if all the $\alpha^i$ values corresponding to all possible code word symbol locations have been tried and all the roots have not been found.

12. The apparatus of claim 11 wherein the means for incrementing said counter does so until either a predetermined number of roots are found or i equals the block length of the code used to encode the data, and the apparatus further includes

K. means for labeling the code word uncorrectable if all the $\alpha^i$ values corresponding to all possible code word symbol locations have been tried and the predetermined number of roots have not been found;

L. means for finding the remaining error locations by using a fast-decode method designed to solve an equation of the predetermined degree.

13. The apparatus of claim 11 further including a means for correcting the errors in the code word using the $\alpha^i$ values corresponding to the error locations.

**Patentansprüche**

1. Verfahren zur Positionsbestimmung von fehlerhaften Symbolen in einem empfangenen Datencodewort, das durch Codierung von Datensymbolen gemäß eines BCH-Codes formuliert ist, wobei das Verfahren folgende Schritte enthält:

A. Empfangen eines Datencodeworts;

B. Bestimmen, ob das Codewort Fehler enthält;

C. wenn das Codewort Fehler enthält, Erzeugen einer Fehlerpositionsanzeigegleichung bezüglich des Codeworts, wobei die Fehlerpositionsanzeigegleichung die Form besitzt:

$$1 + \delta_1 * x + \delta_2 x^2 + \delta_3 * x^3 + ... + \delta_{v-1} * x^{v-1} + \delta_v * v^v = 0$$

wobei * eine Multiplikation über einem zur Codierung von Datensymbolen verwendeten Galois-Feld und + eine Addition über dem Galois-Feld darstellen, und die Wurzeln der Fehlerpositionsanzeigegleichung den Positionen von fehlerhaften Codewortsymbolen entsprechen;

wobei das Verfahren durch die Schritte gekennzeichnet ist:

D. Bestimmen, ob $\alpha^i$, welches der Position eines Datensymbols in dem Codewort entspricht, eine Wurzel der Fehlerpositionsanzeigegleichung ist, und somit Bestimmen, daß das entsprechende Datensymbol fehlerhaft ist, durch:

i. Berechnen (50) mit Hilfe der Koeffizienten der Fehlerpositionsanzeigegleichung des Werts von $\delta_v'$ durch iterative Berechnung von $\delta_j'$ mit j = 1 bis v entsprechend den Formeln:

$$\delta_1' = \delta_1 + \alpha^i$$

$$\delta_2' = \delta_1' * \alpha^1 + \delta_2$$

$$... \delta_v' = \delta_{v-1}' * \alpha^i + \delta_v$$

ii. Vergleichen (51) von $\delta_v'$ mit NULL, und

iii. Speichern von $\alpha^i$ entsprechend der Position eines fehlerhaften Datencodewortsymbols, wenn $\delta_v'$ gleich NULL ist, was bedeutet, daß $\alpha^i$ eine Wurzel der Fehlerpositionsanzeigegleichung ist,

E1. wenn $\alpha^i$ keine Wurzel ist, Versuchen eines nächsten Werts $\alpha^i = \alpha^{i+1}$ (53, 50), der der nächsten Datensymbolposition entspricht, als Wurzel der Fehlerpositionsanzeigegleichung durch Wiederholen des Schritts D;

E2. wenn $\alpha^i$ eine Wurzel ist,

i. Aktualisieren (58) der Fehlerpositionsanzeigegleichung und der Fehlerpositionsanzeigeformeln durch Ersetzen der Koeffizienten mit den in Schritt D berechneten $\delta_j'$-Werten und somit Reduzieren (60) des Grads der Gleichung und der Anzahl der Formeln.

ii. Auswählen eines nächsten Werts $\alpha^i = \alpha^{i+1}$ (62), der der nächsten Datensymbolposition entspricht;

F. Wiederholen der Schritte D und E, bis eine vorbestimmte Anzahl von Fehlerpositionen gefunden worden ist.

2. Verfahren nach Anspruch 1, das weiterhin die Schritte enthält:

G. Bestimmen (72) der restlichen Fehlerpositionen durch Ermitteln der Wurzeln der reduzierten Fehlerpositionsanzeigegleichung mit Hilfe eines schnellen Decodierverfahrens, das die Wurzeln einer Gleichung vorbestimmten Grads ermittelt; und

H. Übertragen des empfangenen Codeworts und der gespeicherten $\alpha^i$-Werte, die den Fehlerpositionen entsprechen, an eine Fehlerkorrekturschaltung zur Korrektur der fehlerhaften Datensymbole.

3. Verfahren nach Anspruch 1, wobei der Schritt des Wiederholens der Schritte D und E weiterhin enthält:

a. Wiederholen der Schritte (50, 51) bis entweder alle Wurzeln der Fehlerpositionsanzeigegleichung ermittelt sind, oder die allen möglichen Codewortsymbolpositionen entsprechenden $\alpha^i$-Werte als mögliche Wurzeln versucht worden sind; und

b. wenn alle Wurzeln ermittelt worden sind, Übertragen des empfangenen Codeworts und der den Fehlerpositionen entsprechenden gespeicherten $\alpha^i$-Werten an eine Fehlerkorrekturschaltung zur Korrektur der fehlerhaften Datensymbole, oder

c. wenn die allen möglichen Codewortsymbolpositionen entsprechenden $\alpha^i$-Werte als mögliche Wurzeln versucht und alle Wurzeln ermittelt worden sind, Kennzeichnen (55) des Datencodeworts als unkorrigierbar.

4. Verfahren zur Positionsbestimmung von fehlerhaften Symbolen in einem empfangenen Datencodewort, das durch Codierung von Datensymbolen gemäß eines BCH-Codes formuliert ist, wobei das Verfahren folgende Schritte enthält:

A. Empfangen eines Datencodeworts;

B. Bestimmen, ob das Codewort Fehler enthält;

C. wenn das Codewort Fehler enthält, Erzeugen einer Fehlerpositionsanzeigegleichung bezüglich des Codeworts, wobei die Fehlerpositionsanzeigegleichung die Form besitzt:

$$1 + \delta_1 * x + \delta_2 x^2 + \delta_3 * x^3 + ... + \delta_{v-1} * x^{v-1} + \delta_v * v^v = 0$$

wobei * eine Multiplikation über einem zur Codierung von Datensymbolen verwendeten Galois-Feld und + eine Addition über dem Galois-Feld darstellen, und die Wurzeln der Fehlerpositionsanzeigegleichung den Positionen von fehlerhaften Codewortsymbolen entsprechen;

das Verfahren ist gekennzeichnet durch die Schritte:

D. Bestimmen, ob $\alpha^i$, welches der Position eines Datensymbols in dem Codewort entspricht, eine Wurzel der Fehlerpositionsanzeigegleichung ist, und somit Bestimmen, daß das entsprechende Datensymbol fehlerhaft ist, durch:

i. Einstellen (150) eines Iterationszählers auf 0;

ii. Addieren (150) der Koeffizienten der Fehlerpositionsanzeigegleichung, und

iii. wenn die Summe gleich EINS (152, 154) ist, was bedeutet, daß $\alpha^i$ eine Wurzel der Fehlerpositionsanzeigegleichung ist, Speichern des Werts $\alpha^i$, wobei i gleich dem Zählerstand des Iterationszählers ist;

E1. wenn $\alpha^i$ eine Wurzel ist (154), Aktualisieren der Fehlerpositionsanzeigegleichung durch Ersetzen (156) der Koeffizienten und Reduzieren (158) des Grads der Gleichung, wobei die Koeffizienten der Fehlerpositionsanzeigegleichung durch deren Ersetzen (156) mit $\delta_j'$-Werten, die gegebenenfalls unter Verwendung der Formeln;

$$\delta_1' = 1 + \delta_1$$

$$\delta_2' = \delta_1' + \delta_2$$

$$\dots \, \delta_v' = \delta_{v-1}' + \delta_v$$

berechnet werden, aktualisiert werden;
die resultierende Fehlerpositionsgleichung hat v-1 Terme;
E2. wenn $\alpha^i$ keine Wurzel ist (160), Aktualisieren (166) der Koeffizienten der Fehlerpositionsanzeigegleichung mit Hilfe der Formeln:

$$\delta_1 = \delta_1 * \alpha$$

$$\delta_2 = \delta_2 * \alpha^2$$

$$\dots \, \delta_v = \delta_v * \alpha^v;$$

F. Erhöhen (162) des Zählers um eins;
G. Wiederholen der Schritte D bis F für fortlaufende Werte von $\alpha^i$.

**5.** Verfahren nach Anspruch 4, wobei die Schritte D und F wiederholt werden bis entweder alle Wurzeln der Fehlerpositionsanzeigegleichung gefunden oder die allen möglichen Codewortsymbolpositionen entsprechenden $\alpha^i$-Werte als mögliche Wurzeln versucht worden sind, und das Verfahren weiterhin die Schritte enthält:

a. wenn alle Fehlerpositionen ermittelt worden sind, Übertragen des empfangenen Codeworts und der den Fehlerpositionen entsprechenden gespeicherten $\alpha^i$-Werten an eine Fehlerkorrekturschaltung zur Korrektur der fehlerhaften Datensymbole; oder
b. wenn die allen möglichen Codewortsymbolpositionen entsprechenden $\alpha^i$-Werte als mögliche Wurzeln versucht und alle Wurzeln ermittelt worden sind, Kennzeichnen des Datencodeworts als unkorrigierbar.

**6.** Verfahren nach Anspruch 4, das weiterhin das Wiederholen der Schritte D-F für fortlaufende Werte von $\alpha^1$ umfaßt, bis entweder eine vorbestimmte Anzahl von Wurzeln ermittelt ist und die reduzierte Fehlerpositionsanzeigegleichung einen vorbestimmten Grad (174) hat, oder die allen möglichen Codewortpositionen entsprechenden $\alpha^i$-Werte als mögliche Wurzeln versucht worden sind; und

a. wenn die allen möglichen Codewortpositionen entsprechenden $\alpha^i$-Werte nicht versucht worden sind:

i. Bestimmen (176) der restlichen Fehlerpositionen mit Hilfe eines schnellen Decodierverfahrens, das zur Ermittlung der Wurzeln einer Gleichung vorbestimmten Grads geeignet ist, und
ii. Übertragen des empfangenen Codeworts und der den Fehlerpositionen entsprechenden $\alpha^i$-Werte an eine Fehlerkorrekturschaltung zur Korrektur der fehlerhaften Datensymbole, oder

b. wenn die allen möglichen Codewortpositionen entsprechenden $\alpha^i$-Werte versucht worden sind, Kennzeichnen des Datencodeworts als unkorrigierbar.

**7.** Gerät zur Positionsbestimmung fehlerhafter Symbole in einem empfangenen Datencodewort, das durch Codieren von Datensymbolen gemäß einem BCH-Code formuliert ist, wobei das Gerät enthält:

A. eine Einrichtung zum Empfang eines Datencodeworts;
B. eine Einrichtung zum Bestimmen, ob das Codewort Fehler enthält;
C. eine Einrichtung zur Erzeugung einer auf das Codewort bezogenen Fehlerpositionsanzeigegleichung für ein Codewort, das Fehler enthält, wobei die Fehlerpositionsanzeigegleichung die Form besitzt:

$$1 + \delta_1 * x + \delta_2 x^2 + \delta_3 * x^3 + \dots + \delta_{v-1} * x^{v-1} + \delta_v * v^v = 0$$

wobei * eine Multiplikation über einem zur Codierung von Datensymbolen verwendeten Galois-Feld und + eine Addition über dem Galois-Feld darstellen, und die Wurzeln der Fehlerpositionsanzeigegleichung den Positionen von fehlerhafen Codewortsymbolen entsprechen;

das Gerät ist gekennzeichnet durch:

D. eine Berechnungseinrichtung (10, 12, 14) zur Berechnung des Werts von $\delta_v{}'$ durch iterative Berechnung von $\delta_j{}'$ mit $j = 1$ bis $v$ für $\alpha^i$, wobei $\alpha^i$ der Position eines Datencodewortsymbols entspricht, mit Hilfe der Koeffizienten der Fehlerpositionsanzeigegleichung entsprechend der Formeln:

$$\delta_1{}' = \delta_1 + \alpha^i$$

$$\delta_2{}' = \delta_1{}' {}^* \alpha^i + \delta_2$$

$$... \ \delta_v{}' = \delta_{v-1}{}' {}^* \alpha^i + \delta_v$$

E. Einrichtung (40) zum Speichern von $\alpha^i$ als Indikator für die Position eines fehlerhaften Symbols, wenn $\delta_v{}'$ gleich NULL ist, was bedeutet, daß $\alpha^i$ eine Wurzel der Fehlerpositionsgleichung ist;

F. Aktualisierungseinrichtung (20, 22, EN, 10), die auf das Finden eines $\alpha^i$-Werts anspricht, welcher eine Wurzel ist, zum Aktualisieren der Fehlerpositionsgleichung und der Fehlerpositionsformeln durch Ersetzen der Koeffizienten durch die von der Berechnungseinrichtung berechneten $\delta_j$-Werte und somit Reduzieren des Grads der Fehlerpositionsanzeigegleichung und der Anzahl von Formeln; und

Einspeisen der aktualisierten Fehlerpositionsanzeigegleichung in die Berechnungseinrichtung (10, 12, 14);

C. Einrichtung (36, 38) zum Einspeisen eines nächsten Werts von $\alpha^i$ - $\alpha^{i+1}$ in die Berechnungseinrichtung;

H. die Berechnungseinrichtung (10, 12, 14), die den Wert von $\delta_v{}'$ für den in sie eingespeisten $\alpha^i$-Wert berechnet, bis eine vorbestimmte Anzahl von Wurzeln gefunden ist.

8. Gerät nach Anspruch 7, wobei die Berechnungseinrichtung (10, 12, 14) die restlichen Fehlerpositionen mit Hilfe eines schnellen Decodierverfahrens, das zum Lösen einer Gleichung vorbestimmten Grads geeignet ist, ermittelt.

9. Gerät nach Anspruch 8, das weiterhin eine Einrichtung zum Korrigieren von Fehlern im empfangenen Codeworte mit Hilfe der der Fehlerpositionen entsprechenden $\alpha^i$-Werte, wenn alle Wurzeln der Fehlerpositionsgleichung bestimmt sind, umfaßt.

10. Gerät nach Anspruch 7, wobei die Einrichtung (36, 38) zum Einspeisen der $\alpha^i$-Werte in die Berechnungseinrichtung entweder alle Werte bis zur Blocklänge des zum Codieren der Daten verwendeten Codes oder Werte, nur bis alle Fehlerpositionen bestimmt sind, einspeist.

11. Gerät zur Positionsbestimmung fehlerhafter Symbole in einem empfangenen Datencodewort, das durch Codieren von Datensymbolen gemäß einem BCH-Code formuliert ist, wobei das Gerät enthält:

A. eine Einrichtung zum Empfang eines Datencodeworts;

B. eine Einrichtung zum Bestimmen, ob das Codewort Fehler enthält;

C. eine Einrichtung zur Erzeugung einer auf das Codewort bezogenen Fehlerpositionsanzeigegleichung bezüglich des Codeworts für ein Codewort, das Fehler enthält, wobei die Fehlerpositionsanzeigegleichung die Form besitzt:

$$1 + \delta_1{}^*x + \delta_2 x^2 + \delta_3{}^*x^3 + ... + \delta_{v-1}{}^*x^{v-1} + \delta_v{}^*v^v = 0$$

wobei * eine Multiplikation über einem zur Codierung von Datensymbolen verwendeten Galois-Feld und + eine Addition über dem Galois-Feld darstellen, und die Wurzeln der Fehlerpositionsanzeigegleichung den Positionen von fehlerhaften Codewortsymbolen entsprechen;

D. einen Iterationszähler (126), der auf einen Anfangswert eingestellt ist,

E. einen Addierer (100, 104) zum Addieren der Koeffizienten der Fehlerpositionsanzeigegleichung;

F. eine Speichereinrichtung (130) zum Speichern der $\alpha^i$-Werte, wobei i dem Zählerstand des Iterationszählers entspricht, als ein Indikator für die Position eines fehlerhaften Symbols, wenn die Koeffizientensumme gleich EINS ist, was bedeutet, daß $\alpha^i$ eine Wurzel der Fehlerpositionsanzeigegleichung ist;

G. eine Aktualisierungseinrichtung einschließlich:

i. einer Kaskadenaddiereinrichtung zum Aktualisieren der Koeffizienten der Fehlerpositionsanzeigegleichung, wenn $\alpha^i$ eine Wurzel ist, das heißt, wenn eine Fehlerposition ermittelt ist, durch Ersetzen der Koeffizienten und Reduzieren des Grads der Fehlerpositionsanzeigegleichung, wobei die Koeffizienten der Fehlerpositionsanzeigegleichung durch deren Ersetzen mit $\delta_j$-Werten, die gegebenenfalls mit Hilfe der Formeln:

$$\delta_1{'} = 1 + \delta_1$$

$$\delta_2{'} = \delta_1{'} + \delta_2$$

$$... \ \delta_v{'} = \delta_{v-1}{'} + \delta_v$$

berechnet werden, ersetzt werden;

die resultierende Fehlerpositionsgleichung hat v-1 Terme; wobei die Aktualisierungseinrichtung die aktualisierten Koeffizienten in den Addierer einspeist, oder

ii. einer Multiplikationseinrichtung (102) zum Aktualisieren der Koeffizienten der Fehlerpositionsanzeigegleichung, wenn ein $\alpha^i$-Wert keine Wurzel ist, mit Hilfe der Formeln:

$$\delta_1 = \delta_1 * \alpha$$

$$\delta_2 = \delta_2 * \alpha^2$$

$$\delta_v = \delta_v * \alpha^v,$$

die Aktualisierungseinrichtung speist die aktualisierten Koeffizienten in den Addierer ein;

H. eine Einrichtung (124) zum Erhöhen des Iterationszählers (126), jedesmal wenn die Aktualisierungseinrichtung aktualisierte Koeffizienten an den Addierer einspeist, vorausgesetzt, daß alle Wurzeln nicht ermittelt worden sind oder i nicht die Codeblocklänge des zum Codieren der Daten verwendeten Codes überschreitet;

I. eine Einrichtung zum Korrigieren der Fehler im Codewort mit Hilfe der gespeicherten $\alpha^i$ Werte, falls alle Wurzeln ermittelt sind; und

J. eine Einrichtung zum Kennzeichnen des Codeworts als unkorrigierbar, wenn alle allen möglichen Codewortsymbolpositionen entsprechenden $\alpha^i$-Werte versucht und alle Wurzeln nicht gefunden worden sind.

12. Gerät nach Anspruch 11, wobei die Einrichtung zum Erhöhen des Zählers solange arbeitet, bis entweder eine vorbestimmte Anzahl an Wurzeln gefunden oder i gleich der Blocklänge des für die Codierung der Daten verwendeten Codes ist, und das Gerät weiterhin enthält:

K. eine Einrichtung zum Kennzeichnen des Codeworts als unkorrigierbar, wenn alle allen möglichen Codewortsymbolpositionen entsprechenden $\alpha^i$-Werte versucht worden sind und die vorbestimmte Anzahl an Wurzeln nicht gefunden worden ist;

L. eine Einrichtung zum Ermitteln der verbleibenden Fehlerpositionen mit Hilfe eines schnellen Decodierverfahrens, das zum Lösen einer Gleichung vorbestimmten Grads geeignet ist.

13. Gerät nach Anspruch 11, das weiterhin eine Einrichtung zum Korrigieren der Fehler im Codewort mit Hilfe der den Fehlerpositionen entsprechenden $\alpha^1$-Werte enthält.

## Revendications

1. Méthode de détermination des emplacements de symboles erronés dans un mot de code de données reçu, formulé par codage de symboles de données selon un code hexadécimal codé binaire (BCH), ladite méthode comprenant les étapes consistant à :

A. recevoir un mode de code de données;

B. déterminer la présence éventuelle d'erreurs dans le mot de code;

C. si le mot de code contient des erreurs, générer une équation de localisation d'erreurs relative au mot de code, l'équation de localisation d'erreurs étant de la forme suivante :

$$1 + \delta_1{*}x + \delta_2{*}x^2 + \delta_3{*}x^3 + ... + \delta_{v-1}{*}x^{v-1} + \delta_v{*}x^v = 0$$

où * représente une multiplication sur un domaine de Galois utilisé pour coder les symboles de données, où + représente une addition sur le domaine de Galois et où les racines de l'équation de localisation d'erreurs correspondent aux emplacements des symboles de mot de code de données erronés;
méthode caractérisée par les étapes consistant à :
D. déterminer si $\alpha^i$, $\alpha^i$ correspondant à l'emplacement d'un symbole de données dans le mot de code, est une racine de l'équation de localisation d'erreurs, et déterminer ainsi que le symbole de données correspondant est erroné :

i. en calculant (50), à partir des coefficients de l'équation de localisation d'erreurs, la valeur de $\delta_v'$ en calculant par itération $\delta_j'$ avec j=1 à v à partir des formules :

$$\delta_1' = \delta_1 + \alpha^i$$

$$\delta_2' = \delta_1'{}^*\alpha^j + \delta_2$$

$$... \ \delta_v' = \delta_{v-1}'{}^*\alpha^i + \delta_v$$

ii. en comparant (51) $\delta_v'$ à ZERO, et
iii. en mémorisant $\alpha^i$ comme correspondant à l'emplacement d'un symbole erroné du mot de code de données si $\delta_v'$ est égal à ZERO, ce qui signifie que $\alpha^i$ est une racine de l'équation de localisation d'erreurs;

E1. si $\alpha^i$ n'est pas une racine, essayer comme racine de l'équation de localisation d'erreurs une valeur suivante de $\alpha^i = \alpha^{i+1}$ (53,50) correspondant à l'emplacement du symbole de données suivant, en répétant l'étape D;
E2. si $\alpha^i$ est une racine :

i. actualiser (58) l'équation de localisation d'erreurs et les formules de localisation d'erreurs en remplaçant les coefficients par les valeurs $\delta_j'$ calculées à l'étape D de manière à réduire (60) le degré de l'équation et le nombre des formules,
ii. choisir une valeur suivante de $\alpha^i = \alpha^{i+1}$ (62) correspondant à l'emplacement du symbole de données suivant;

F. répéter les étapes D et E jusqu'à ce qu'un nombre prédéterminé d'emplacements d'erreurs aient été trouvés.

2. Méthode selon la revendication 1, comprenant en outre les étapes consistant à :

G. déterminer (72) les emplacements d'erreurs restants en trouvant les racines de l'équation de localisation d'erreurs réduite au moyen d'une méthode de décodage rapide permettant de trouver les racines d'une équation du degré prédéterminé; et
H. transmettre le mot de code reçu et les valeurs $\alpha^i$ stockées correspondant aux emplacements d'erreurs à un circuit de correction d'erreurs destiné à corriger les symboles de données erronés.

3. Méthode selon la revendication 1, dans laquelle l'étape de répétition des étapes D et E consiste en plus à :

a. répéter les étapes (50,51) jusqu'à ce que toutes les racines de l'équation de localisation d'erreurs aient été trouvées ou bien que les valeurs de $\alpha^i$ correspondant à tous les emplacements de symboles du mot de code possibles aient été essayées comme racines possibles; et
b. si toutes les racines ont été trouvées, transmettre le mot de code reçu et les valeurs $\alpha^i$ stockées correspondant aux emplacements d'erreurs à un circuit de correction d'erreurs destiné à corriger les symboles de données erronés; ou
c. si les valeurs de $\alpha^i$ correspondant à tous les emplacements de symboles du mot de code possibles ont été essayées comme racines possibles et que les racines n'ont pas toutes été trouvées, à étiqueter (55) le mot de code de données comme impossible à corriger.

4. Méthode de détermination des emplacements de symboles erronés dans un mot de code de données reçu, formulé par codage de symboles de données selon un code BCH, ladite méthode comprenant les étapes consistant à :

A. recevoir un mode de code de données;
B. déterminer la présence éventuelle d'erreurs dans le mot de code;
C. si le mot de code contient des erreurs, générer une équation de localisation d'erreurs relative au mot de code, l'équation de localisation d'erreurs étant de la forme suivante :

$$1 + \delta_1{}^*x + \delta_2{}^*x^2 + \delta_3{}^*x^3 + ... + \delta_{v-1}{}^*x^{v-1} + \delta_v{}^*x^v = 0$$

où * représente une multiplication sur un domaine de Galois utilisé pour coder les symboles de données, où + représente une addition sur le domaine de Galois et où les racines de l'équation de localisation d'erreurs correspondent aux emplacements des symboles du mot de code de données erronés;

méthode caractérisée par les étapes consistant à :

D. déterminer si $\alpha^i$, $\alpha^i$ correspondant à l'emplacement d'un symbole de données dans le mot de code, est une racine de l'équation de localisation d'erreurs, et déterminer ainsi que le symbole de données correspondant est erroné :

i. en mettant à 0 (150) un compteur d'itération;
ii. en additionnant (150) les coefficients de l'équation de localisation d'erreurs; et
iii. si la somme est égale à UN (512, 154), en indiquant que $\alpha^i$ est une racine de l'équation de localisation d'erreurs et en stockant la valeur $\alpha^i$ où i est égal au comptage du compteur d'itération;

E1. si $\alpha^i$ est une racine (154), actualiser l'équation de localisation d'erreurs en remplaçant (156) les coefficients et en réduisant (158) le degré de l'équation, lesdits coefficients de l'équation de localisation d'erreurs étant actualisés en les remplaçant (156) par les valeurs $\delta_j'$ calculées au moyen des formules suivantes :

$$\delta_1' = 1 + \delta_1$$

$$\delta_2' = \delta_1' + \delta_2$$

$$... \delta_v' = \delta_{v-1}' + \delta_v$$

l'équation de localisation d'erreurs résultante ayant v-1 termes;

E2. si $\alpha^i$ n'est pas une racine (160), actualiser (166) les coefficients de l'équation de localisation d'erreurs en utilisant les formules :

$$\delta_1 = \delta_1 * \alpha$$

$$\delta_2 = \delta_2 * \alpha^2$$

$$... \delta_v = \delta_v * \alpha^v$$

F. incrémenter (162) ledit compteur de un;
G. répéter les étapes D à F pour les valeurs successives de $\alpha^i$.

5. Méthode selon la revendication 4, dans laquelle les étapes D et E sont répétées jusqu'à ce que toutes les racines de l'équation de localisation d'erreurs aient été trouvées ou bien que les valeurs de $\alpha^i$ correspondant à tous les emplacements de symboles du mot de code possibles aient été essayées comme racines possibles, la méthode comprenant en plus les étapes consistant à :

a. si tous les emplacement d'erreur ont été trouvés, transmettre le mot de code reçu et les valeurs $\alpha^i$ stockées correspondant aux emplacements d'erreurs à un circuit de correction d'erreurs destiné à corriger les symboles de données erronés; ou
b. si les valeurs de $\alpha^i$ correspondant à tous les emplacements de symboles de mot de code possibles ont été essayées comme racines possibles et que les racines n'ont pas toutes été trouvées, à étiqueter le mot de code de données comme impossible à corriger.

6. Méthode selon la revendication 4, comportant en plus la répétition des étapes D à F pour des valeurs successives de $\alpha^i$ jusqu'à ce qu'un nombre prédéterminé de racines soient trouvées et que l'équation de localisation d'erreurs réduite soit d'un degré prédéterminé (174) ou bien que les valeurs $\alpha^i$ correspondant à tous les emplacements de mots de code possibles aient été essayées comme racines possibles; et

a. si les valeurs de $\alpha^i$ correspondant à tous les emplacements de mots de code possibles n'ont pas été essayées :

i. déterminer (176) les emplacements d'erreurs restants en utilisant une méthode de décodage rapide permettant de trouver les racines d'une équation du degré prédéterminé; et

ii. transmettre le mot de code reçu et les valeurs $\alpha^i$ stockées correspondant aux emplacements d'erreurs à un circuit de correction d'erreurs destiné à corriger les symboles de données erronés, ou

b. si les valeurs de $\alpha^i$ correspondant à tous les emplacements de symboles de mots de code possibles ont été essayées, à étiqueter le mot de code de données comme impossible à corriger.

7. Appareil destiné à déterminer les emplacements de symboles erronés dans un mot de code de données reçu, formulé par codage de symboles de données selon un code BCH, ledit appareil comprenant :

   A. des moyens de réception d'un mot de code de données;
   B. des moyens de détermination de la présence éventuelle d'erreurs dans le mot de code;
   C. des moyens de génération, si le mot de code contient des erreurs, d'une équation de localisation d'erreurs relative au mot de code, l'équation de localisation d'erreurs étant de la forme suivante :

   $$1 + \delta_1 {}^*x + \delta_2 {}^*x^2 + \delta_3 {}^*x^3 + \ldots + \delta_{v-1} {}^*x^{v-1} + \delta_v {}^*x^v = 0$$

   où * représente une multiplication sur un domaine de Galois utilisé pour coder les symboles de données, où + représente une addition sur le domaine de Galois et où les racines de l'équation de localisation d'erreurs correspondent aux emplacements des symboles du mot de code de données erronés;
   cet appareil étant caractérisé par :
   D. des moyens de calcul (10,12,14) permettant de calculer pour $\alpha^i$, $\alpha^i$ correspondant à l'emplacement d'un symbole de données dans le mot de code, en utilisant les coefficients de l'équation de localisation d'erreurs, la valeur de $\delta_v{}'$ en calculant par itération $\delta_j{}'$ avec j=1 à v à partir des formules :

   $$\delta_1{}' = \delta_1 + \alpha^i$$

   $$\delta_2{}' = \delta_1{}'{}^*\alpha^i + \delta_2$$

   $$\ldots \ \delta_v{}' = \delta_{v-1}{}'{}^*\alpha^i + \delta_v$$

   E. des moyens (40) de mémorisation de $\alpha^i$ comme indiquant l'emplacement d'un symbole erroné si $\delta_v{}'$ est égal à ZERO, ce qui signifie que $\alpha^i$ est une racine de l'équation de localisation d'erreurs;
   F. des moyens d'actualisation (20, 22, EN, 10) réagissant au fait de trouver une valeur $\alpha^i$ qui soit une racine, destinés à actualiser l'équation de localisation d'erreurs et les formules de localisation d'erreurs en remplaçant les coefficients par les valeurs $\delta_j$ calculées par lesdits moyens de calcul, réduisant ainsi le degré de l'équation de localisation d'erreurs et le nombre de formules; et
   en fournissant l'équation de localisation d'erreurs actualisée auxdits moyens de calcul (10,12,14);
   G. des moyens (36,38) pour fournir auxdits moyens de calcul une valeur suivante $\alpha^i = \alpha^{i+1}$;
   H. lesdits moyens de calcul (10,12,14) calculant la valeur de $\delta_v{}'$ pour la valeur de $\alpha^i$ qui leur a été fournie jusqu'à ce qu'un nombre prédéterminé de racines aient été trouvées.

8. Appareil selon la revendication 7, dans lequel les moyens de calcul (10,12,14) trouvent les emplacements d'erreurs restants en utilisant une méthode de décodage rapide conçue pour résoudre une équation du degré prédéterminé.

9. Appareil selon la revendication 8, comprenant en outre des moyens de correction des erreurs présentes dans le mot de code reçu en utilisant les valeurs $\alpha^i$ correspondant aux emplacements d'erreurs si toutes les racines de l'équation de localisation d'erreurs ont été déterminées.

10. Appareil selon la revendication 7, dans lequel les moyens (36,38) pour fournir les valeurs $\alpha^i$ aux moyens de calcul fournissent toutes les valeurs jusqu'à la longueur de bloc du code utilisé pour coder les données, ou bien fournissent des valeurs uniquement jusqu'à ce que tous les emplacements d'erreurs aient été déterminés.

11. Appareil destiné à déterminer les emplacements de symboles erronés dans un mot de code de données reçu, formulé par codage de symboles de données selon un code BCH, ledit appareil comprenant :

   A. des moyens de réception d'un mot de code de données;
   B. des moyens de détermination de la présence éventuelle d'erreurs dans le mot de code;
   C. des moyens de génération, si le mot de code contient des erreurs, d'une équation de localisation d'erreurs relative au mot de code, l'équation de localisation d'erreurs étant de la forme suivante :

$$1 + \delta_1 {}^*x + \delta_2 {}^*x^2 + \delta_3 {}^*x^3 + ... + \delta_{v-1} {}^*x^{v-1} + \delta_v {}^*x^v = 0$$

où * représente une multiplication sur un domaine de Galois utilisé pour coder les symboles de données, où + représente une addition sur le domaine de Galois et où les racines de l'équation de localisation d'erreurs correspondent aux emplacements des symboles du mot de code de données erronés;

D. un compteur d'itération (126) réglé à une valeur initiale;

E. un additionneur (100, 104) destiné à additionner les coefficients de l'équation de localisation d'erreurs;

F. des moyens de stockage (130) destinés à stocker les valeurs $\alpha^i$, i étant égal au comptage du compteur d'itération, comme indiquant l'emplacement d'un symbole erroné si la somme des coefficients est égale à UN, ce qui signifie que $\alpha^i$ est une racine de l'équation de localisation d'erreurs;

G. des moyens d'actualisation comprenant :

i. des moyens additionneurs en cascade destinés à actualiser les coefficients de l'équation de localisation d'erreurs lorsque $\alpha^i$ est une racine, c'est-à-dire lorsqu'un emplacement d'erreur a été trouvé, en remplaçant les coefficients et en réduisant le degré de l'équation de localisation d'erreurs, lesdits coefficients de l'équation de localisation d'erreurs étant actualisés en les remplaçant (156) par les valeurs $\delta_j'$ calculées au moyen des formules suivantes :

$$\delta_1' = 1 + \delta_1$$

$$\delta_2' = \delta_1' + \delta_2$$

$$... \delta_v' = \delta_{v-1}' + \delta_v$$

l'équation de localisation d'erreurs résultante ayant v-1 termes; lesdits moyens d'actualisation fournissant les coefficients actualisés à l'additionneur; ou

ii. des moyens multiplicateurs (102) pour actualiser les coefficients de l'équation de localisation d'erreurs, si une valeur $\alpha^i$ n'est pas une racine, en utilisant les formules suivantes :

$$\delta_1 = \delta_1 {}^* \alpha$$

$$\delta_2 = \delta_2 {}^* \alpha^2$$

$$... \delta_v = \delta_v {}^* \alpha^v$$

lesdits moyens d'actualisation fournissant les coefficients actualisés à l'additionneur;

H. des moyens (124) d'incrémentation dudit compteur d'itération (126) chaque fois que lesdits moyens d'actualisation fournissent des coefficients actualisés audit additionneur, à la condition que les racines n'aient pas toutes été trouvées ou bien que i ne soit pas supérieur à la longueur de bloc du code utilisé pour coder les données;

I. des moyens de correction des erreurs présentes dans le mot de code utilisant les valeurs $\alpha^i$ stockées si toutes les racines ont été trouvées; et

J. des moyens d'étiquetage du mot de code comme impossible à corriger si toutes les valeurs $\alpha^i$ correspondant à tous les emplacements de symboles du mot de code possibles ont été essayées et que les racines n'ont pas toutes été trouvées.

12. Appareil selon la revendication 11, dans lequel les moyens d'incrémentation dudit compteur incrémentent ce dernier jusqu'à ce qu'un nombre prédéterminé de racines aient été trouvées ou bien que i soit égal à la longueur de bloc du code utilisé pour coder les données, l'appareil comprenant en outre :

K. des moyens d'étiquetage du mot de code comme impossible à corriger si toutes les valeurs $\alpha^i$ correspondant à tous les emplacements de symboles du mot de code possibles ont été essayées et que le nombre de racines prédéterminé n'a pas été trouvé;

L. des moyens de trouver les emplacements d'erreurs restants en utilisant une méthode de décodage rapide conçue pour résoudre une équation du degré prédéterminé.

13. Appareil selon la revendication 11, comportant en outre des moyens de correction des erreurs présentes dans le mot de code en utilisant les valeurs $\alpha^i$ correspondant aux emplacements d'erreurs.

FIG. 1

EP 0 341 862 B1

50 – SUBSTITUTE $x = \alpha^i$ IN FORMULA 2 AND CALCULATE $\delta_1' \cdots \delta_V'$

51 – IS $\delta_V'$ EQUAL TO ZERO ? —— NO ——→ 52 – X IS NOT A ROOT

53 – $\alpha^i = \alpha^{i+1}$

54 – IS $i+1 < p^{\gamma}-1$ —— YES

NO

55 – LABEL DATA UNCORRECTABLE

YES

56 – X IS A ROOT

58 – MODIFY THE COEFFICIENTS OF $\delta(X)$

$$\delta_1 = \delta_1', \quad \delta_2 = \delta_2'$$

$$\cdots$$

$$\delta_{V-1} = \delta_{V-1}'$$

60 – REDUCE THE DEGREE OF $\delta(X)$ BY ONE

62 – $\alpha^i = \alpha^{i+1}$

64 – IS $i + 1 < p^{\gamma} - 1$ ? —— YES

NO

LABEL DATA UNCORRECTABLE

GO TO STEP 50

OR

FIG. 2A               Ⓐ  FIGURE 2B

20

(A)

70  IS DEGREE OF $\sigma(X)$ = T, WHERE T
IS 2, 3 OR 4 (T SELECTED BY SYSTEM —————— NO
DESIGN)

|YES

72  USE FAST-DECODE METHOD TO
SOLVE FOR REMAINING ROOTS

GO TO
STEP 50
FIGURE 2A

## FIG. 2B

FIG. 3

150 – ADD COEFFIENTS OF ERROR LOCATOR
EQUATION        SET i = 0

152 – SUM EQUAL TO ONE ?

YES        NO

154 – X = $\alpha^i$ IS A ROOT

160 – X = $\alpha^i$ IS NOT A ROOT

156 – MODIFY THE COEFFICIENTS $\delta_V'$ BY FORMULAS

$$\delta_1' = 1 + \delta_1$$
$$\delta_2' = \delta_1' + \delta_2$$
$$\cdots$$
$$\delta_V' = \delta_{V-1}' + \delta_V$$

162 – i = i + 1

164 – IS i ≤ $p^q - 1$

YES        NO

LABEL DATA UNCORRECT-ABLE

158 – REDUCE NUMBER OF FORMULAS BY ONE

166 – UPDATE COEFFICIENTS

$$\delta_1 = \delta_1 * \alpha^1$$
$$\delta_2 = \delta_2 * \alpha^2$$
$$\cdots$$
$$\delta_V = \delta_V * \alpha^V$$

TO 174
FIGURE 4B

168 – ADD UPDATED COEFFICIENTS TO CALCULATE $S_V$

170 – DOES $S_V$ EQUAL ONE ?

YES        NO

GO TO STEP 154        GO TO STEP 160

FIG. 4A

Ⓑ

174 IS DEGREE OF $\mathcal{S}(X) = T$ WHERE T IS
2,3 OR 4 (T SELECTED BY SYSTEM
DESIGN)

NO                    YES

176 USE FAST DECODE
METHOD TO SOLVE
FOR REMAINING ROOTS

GO TO STEP 160
FIGURE 4A

FIG. 4B